# EUROPEAN PATENT APPLICATION

(11) **EP 1 202 296 A1**
(43) Date of publication of application: **02.05.2002**
(21) Application number: 01125671.6
(22) Date of filing: 26.10.2001
(51) Int. Cl.: H01F 17/00, H01L 23/64

(54) **Out-of-plane microcoil using bonding wires and method for making**

(30) Priority: 27.10.2000 US 699233
(71) Applicant: Xerox Corporation, Rochester, New York 14644 (US)
(72) Inventor: Van Schuylenbergh, Koenraad F., Mountain View, CA 94041 (US); Fork, David K., Los Altos, California 94024 (US)
(74) Representative: Grünecker, Kinkeldey, Stockmair & Schwanhäusser Anwaltssozietät

(57) **Abstract**

An out-of-plane microcoil (e.g., inductor) including conductive traces formed on a substrate, and then connecting the conductive traces using standard wire bonding techniques. The conductive traces of each microcoil include first and second spaced-apart contact pads, and an elongated interconnect line located between the first and second contact pads. Wire bonding is then performed to place a first wire such that the wire extends from the first contact pad over the substrate surface to a first end of the interconnect line, and to place a second wire such that the wire extends from the second contact pad over the substrate to a second end of the interconnect line. The conductive traces are formed during the final metallization step typically used to form device contact pads on the IC substrate. The wires are placed during, for example, device packaging (i.e., connection of the IC substrate to package terminals). Modern ICs typically require dozens to hundreds of such bonding wires, so the addition of a few wires to produce out-of-plane microcoils does not significantly increase the packaging time or expense.

## Description

### FIELD OF THE INVENTION

This invention generally relates to integrated circuits, and more particularly to integrated circuits (ICs) including on-chip inductors.

### DISCUSSION OF RELATED ART

Low-loss on-chip inductors (i.e., that are integrated on an IC substrates) are desirable in wireless communication devices such as cellular phones, pagers, GPS receivers, warehouse management RF identification tags, wireless computer LANs, personal digital assistants, and satellite telecommunication. Small portable devices, in particular, require the lowest possible power consumption for extended battery life and a maximal circuit integration to reduce device size and PC board complexity. The quest for low-loss inductors is driven by a fundamental trade-off between power consumption on one hand and the need for low-loss circuit passives (i.e., inductors and capacitors) on the other. Lowering the transistor bias in radio circuits reduces the power dissipation, but also significantly degrades amplifier gains, oscillator stability and filter selectivity. Using low-loss passives is the only viable technique to overcome this problem. However, many state-of-the art integrated coil architectures are still too lossy to be of use in integrated RF designs. Most present RF chipsets, therefore, are limited to using discrete inductors that take up valuable board space and increase board complexity. In addition, connections must be provided between an IC device and the discrete inductors, thereby requiring an IC package with a higher pin count (i.e., to support communication between the IC device and the discrete inductors) than that required if the inductors were integrated (i.e., fabricated directly on) the IC device. Higher pin count IC packages are typically larger and more expensive than lower pin count packages.

Accordingly, the integration of small inductors on silicon substrates has been the subject of intense worldwide research for many years. The structures proposed so far, however, have been variations of devices in which, due to technological constraints, the coil windings have almost always been implemented as spirals parallel to the underling substrate.

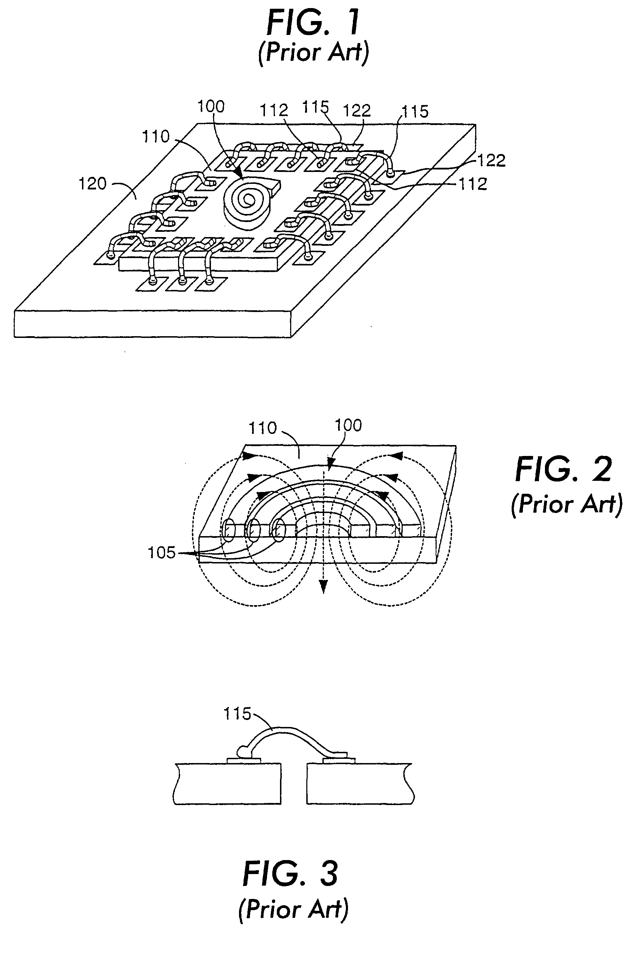

Fig. 1 is a perspective view showing a simplified in-plane spiral coil winding 100 formed on an IC substrate 110, which in turn is mounted on a package or printed circuit board (PCB) 120. Note that coil winding 100 is substantially disk-shaped, and lies in a plane that is parallel to the upper surface of substrate 110. Contact pads 112, which are formed on the upper surface of IC substrate 110, are connected by conventional bonding wires 115 to corresponding pads 122 formed on package/PCB 120.

Fig. 2 is a perspective cut-away view showing a portion of in-plane coil winding 100 and indicating the magnetic fields (i.e., dashed lines) generated in the vicinity of coil winding 100 during operation. This figure illustrates two major drawbacks of in-plane coil winding 100. First, when substrate 110 is slightly conducting, such as silicon, the coil magnetic fields (dashed lines in Fig. 2) induce eddy currents in underlying substrate 110. These currents cause resistive dissipation that contributes to the coil losses. The second problem arises when coil winding 100 is operated at high frequencies, where skin and proximity effects force the coil current to flow along the outer surfaces 105 of coil winding 100 (as indicated by shaded regions located at the outer edges of coil winding 100). The "skin depth" is about 2 to 3 microns for typical conductors at frequencies of interest for wireless communication, for example, 900 MHz, 1.9 GHz and 2.4 GHz. The AC resistance of the coil conductor becomes appreciably higher than its DC resistance because the cross section of the conductor is not fully used.

Solutions have been proposed and tried in the past to address the drawbacks associated with in-plane inductors. Eddy currents can be reduced, for example, by etching away the substrate underneath the coil. However, this approach is not practical as it sacrifices structural integrity and destroys existing electronic circuitry on the silicon substrate. To reduce the AC resistance of the device in Fig. 2, the conductor can be made very thick using micromachining techniques such as LIGA (see "The LIGA Technique - What are the New Opportunities", A. Rogner et al., J. Micromech. Microeng., vol. 2, 1992, pages 133-140). However, processing high aspect ratio structures is difficult and expensive.

Various out-of-plane techniques have been suggested that address the induced current eddy problems of in-plane coil structures. One such out-of-plane miniature coil structure that can be used as an on-chip inductor is disclosed in co-owned and co-pending U.S. Patent Application Serial No. 09/573,815, filed May 17, 2000, entitled "Photolithographically-Patterned Out-Of-Plane Coil Structures and Method of Making". The coil structure includes a lithographically produced elastic member having an intrinsic stress profile that is formed on the IC substrate. The elastic member includes a first anchor portion fixed to the substrate, a loop winding and a second anchor portion connected to the substrate. The second anchor portion and the loop winding are initially fixed to the substrate, but are released from the substrate to become separated from the substrate. An intrinsic stress profile in the elastic member biases the second anchor portion away from the substrate forming the loop winding and causing the second anchor portion to contact the substrate. The resulting coil structure is out-of-the plane of the IC substrate, thereby greatly reducing induced eddy currents in the underlying substrate when compared to in-plane coil structures (discussed above).

A problem with the method disclosed in U.S. Patent Application Serial No. 09/573,815 is that it requires an additional layer and associated fabrication steps (i.e., in addition to those needed to form the underlying IC device) that significantly increase chip manufacturing costs. Specifically, the elastic member is formed during a special metal deposition process in which process parameters are varied to generate the required intrinsic stress profile, and requires dedicated post-deposition photolithography and other processing conditions. Adding one layer to an existing process typically increases the chip manufacturing cost by 4 to 10%. In some application fields (e.g., cell phones and other wireless devices), the profit margins for such ICs are in that 4 to 10% range, or even lower. Hence, such chip manufacturing cost increases can be too high to utilize in these applications.

There is a need for an out-of-plane microcoil structure that can be integrated onto an IC substrate without significantly increasing chip manufacturing costs (i.e., using existing fabrication steps). There is a need for a low-cost manufacturing technique that produces a closed coil structure suitable for high-Q integrated passive inductor elements.

### SUMMARY OF THE INVENTION

The present invention is directed to a method for forming out-of-plane microcoils (e.g., inductors) on an integrated circuit (IC) substrate by forming conductive traces on an upper surface of the IC substrate, and then connecting the conductive traces using standard wire bonding techniques. The conductive traces of each microcoil include first and second spaced-apart contact pads, and an elongated interconnect line located between the first and second contact pads. Wire bonding is then performed to place a first bonding wire (first wire) such that the first wire extends from the first contact pad over the substrate surface to a first end of the interconnect line, and to place a second bonding wire (second wire) such that the second wire extends from the second contact pad over the substrate to a second end of the interconnect line. Inductance is generated during subsequent operation by passing the current through the first contact pad (on the substrate surface) along the arch of the first wire to the interconnect line, along the interconnect line to the second wire, and along the second wire the second contact pad.

In accordance with a first aspect of the present invention, the microcoil windings (i.e., conductive traces and bonding wires) can be formed entirely during existing fabrication steps (i.e., no additional procedures are required). The conductive traces are formed during the final metallization step typically used to form device contact pads on the IC substrate. Wire bonding is typically used during device packaging to connect IC substrates to package terminals. Modern ICs typically require dozens to hundreds of such bonding wires, so the addition of a few wires to produce out-of-plane microcoils does not significantly increase the packaging time or expense. Accordingly, microcoils produced in accordance with the present invention do not require expensive special procedural steps, as required by prior art methods, thereby greatly reducing the cost of producing ICs having on-chip inductive elements.

In accordance with a second aspect of the present invention, the out-of-plane microcoils provide high-Q inductors that produce substantially less induced eddy current in the underlying substrate when compared to prior art in-plane microcoils. Each bonding wire is formed in an exaggerated arched shape (i.e., in comparison to conventional bonding wire contacts), and the overall inductance is adjusted, for example, by increasing the area circumscribed by the bonding wires and the substrate traces, or by increasing the number of series-connected bonding wires. To avoid spacing issues related to conventional wire bond equipment, the density of bonding wires can be increased by utilizing bonding wires having different sizes that are connected together to form a single inductor. If needed, inductance can be further adjusted by mounting an elongated core structure on the substrate over the interconnect line such that the core structure extends through the arch formed by each of the wires. Because the axis of the microcoil is horizontal (i.e., parallel to the substrate surface), few magnetic flux lines intercept the underlying substrate, thereby minimizing induced eddy currents. To further reduce eddy currents, the microcoil can be arranged to form a toroidal structure that further confines magnetic fields to regions above the substrate surface (i.e., inside the windings of the toroidal structure). This feature enables multiple microcoils to be packed densely on the substrate surface without coupling with each other.

In accordance with an alternative embodiment of the present invention, a method is provided for producing IC devices with on-chip microcoil structures that includes (a) placing the microcoil wires on a wafer (i.e., before dicing the wafer to form individual IC substrates), forming (e.g., electroplating) a low-resistance metal coating on the microcoil bonding wires, and then dicing the wafer. An optional second wire bonding process is performed during subsequent packaging of the individual IC substrates. Although this wire coating process increases the chip manufacturing costs by introducing a pre-dice wire bonding process, thereby increasing the required number of process steps, the resulting coated wires provide superior performance characteristics in high frequency applications.

### BRIEF DESCRIPTION OF THE DRAWINGS

The advantages, features and design of the invention will become apparent from the following detailed description of the invention and the accompanying drawings in which like reference numerals refer to like elements and in which:
Fig. 1 is a perspective view showing an integrated circuit device with a conventional inductor;
Fig. 2 is a cut-away perspective view showing electro-magnetic fields generated by a conventional on-chip inductor;
Fig. 3 is a side elevation view showing a conventional wire formed using wire bonding techniques;
Fig. 4 is a perspective view showing an IC device with an on-chip out-of-plane microcoil structure according to a first embodiment of the present invention;
Fig. 5 is a side elevation view of the microcoil structure shown in Fig. 4;
Fig. 6 is a plan view of the microcoil structure shown in Fig. 4;
Figs. 7(A) through 7(C) are cross-sectional side views showing wires utilized in accordance with various embodiments of the present invention;
Figs. 8(A) through 8(H) are cross-sectional side views showing sequential processing steps for generating microcoil structures having metal coated wires in accordance with an alternative production method according to the present invention;
Fig. 9 is a perspective view showing an inductor formed in accordance with a second embodiment of the present invention;
Fig. 10(A) is a perspective view showing an out-of-plane inductor according to a third embodiment of the present invention;
Fig. 10(B) is a side elevation view showing the out-of-plane inductor shown in Fig. 10(A);
Fig. 11(A) is a perspective view showing an out-of-plane inductor according to a fourth embodiment of the present invention;
Fig. 11(B) is a side elevation view showing the out-of-plane inductor shown in Fig. 11(A);
Fig. 12(A) is an exploded perspective view showing a toroid formed in accordance with a fifth embodiment of the present invention;
Fig. 12(B) is a perspective view showing the toroid of the fifth embodiment;
Fig. 13(A) is an exploded perspective view showing a transformer formed in accordance with a sixth embodiment of the present invention;
Fig. 13(B) is a perspective view showing the transformer of the sixth embodiment;
Fig. 14 is an exploded perspective view showing a transformer formed in accordance with a seventh embodiment of the present invention;
Fig. 15(A) is a perspective view showing a cell phone incorporating a radio circuit section including microcoil structure formed in accordance with the present invention;
Fig. 15(B) is a simplified circuit diagram showing the radio circuit section utilized in the cell phone of Fig. 15(A); and
Figs. 16(A) and 16(B) are simplified circuit and perspective views showing a mixer circuit utilized in the cell phone shown in Fig. 15(A).

### DETAILED DESCRIPTION

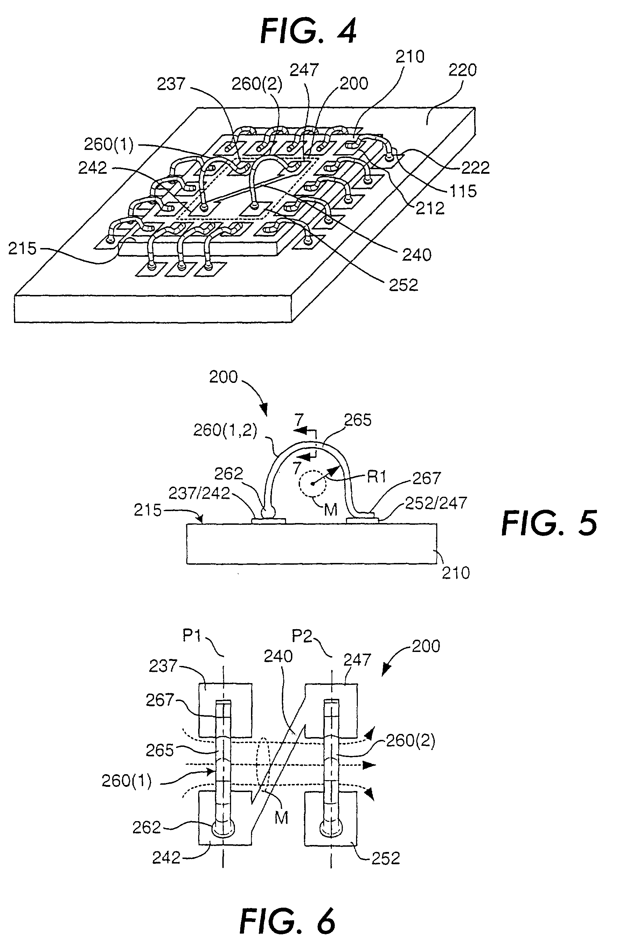

Fig. 4 is a perspective view showing an integrated circuit device including a simplified out-of-plane microcoil structure 200 according to a first embodiment of the present invention. Microcoil structure 200 is formed on an upper surface 215 of a semiconductor (e.g., silicon) substrate 210. Although not shown in detail an IC device is formed on substrate 210 below upper surface 215. Similar to the conventional IC device shown in Fig. 1 (discussed above), contact pads 212 are provided on upper surface 215 that provide electrical connections to the underlying IC device. Contact pads 212 are connected by conventional bonding wires 115 to corresponding pads 222 formed on an external structure (e.g., a package or printed circuit board (PCB)) 220.

In accordance with the present invention, microcoil structure 200 includes several conductive traces (e.g., pads and interconnect lines) formed on upper surface 215 of substrate 210, and several bonding wires (also referred to herein as "wires") linking the conductive traces in the manner described below. In the embodiment shown in Fig. 4, the conductive traces include a first contact pad 237, a second contact pad 252 spaced apart from first contact pad 237, and an elongated interconnect line 240 located between first contact pad 237 and second contact pad 252. Microcoil structure 200 includes a first wire 260(1) having a first end disposed on first contact pad 237, a second end disposed on an end (third contact) pad 242 located at a first end of elongated interconnect line 240, and an arched central portion extending over substrate 210 between first contact pad 237 and the first end of interconnect line 240. Finally, microcoil structure 200 includes a second wire 260(2) has a first end disposed on an end (fourth contact) pad 247 located at a second end of elongated interconnect line 240, a second end disposed on second contact pad 252, and an arched central portion extending over substrate 210 between second contact pad 252 and the second end of interconnect line 240. Wires 260(1) and 260(2) are made from typical metals used for bond wire, such as gold and aluminum.

In accordance with the present invention, microcoil structure 200 is formed on substrate 210 by first forming first contact pad 237, second contact pad 252, and elongated interconnect line 240 on upper surface 215, and then connecting these conductive traces with wires 260(1) and 260(2) using wire bonding techniques.

In one embodiment, the conductive traces are patterned during the same metallization step used to make device contact pads 212, which are used to connect the IC device formed on substrate 210 to an external package or PCB 220. Accordingly, the conductive traces of microcoil structure 200 are provided without increasing the number of chip processing steps that are otherwise needed to fabricate the IC device. Similarly, wires 260(1) and 260(2) are formed during the same wire bonding process used to form bonding wires 215 between substrate 210 and external package or PCB 220. Although only a small number of bonding wires 215 are shown in Fig. 1, most modern IC devices typically require dozens to hundreds of such bonding wires, so the addition of wires 260(1) and 260(2) to produce out-of-plane microcoil structure 200 does not significantly increase the packaging time or expense. Further, experiments conducted on inductors incorporating microcoil structure 200 indicate that these inductors exhibit high-Q values (30 or greater) and produce substantially less induced eddy current in the underlying substrate when compared to prior art in-plane microcoils. Accordingly, microcoil structure 200 provides inductors and other passive elements having excellent performance characteristics and do not require expensive special procedural steps, as required by prior art methods, thereby providing significantly lower chip manufacturing costs than those of the conventional in-plane and out-of-plane conventional coil structures described above.

The present invention is not limited to the above embodiments. Specifically, the conductive traces (e.g., pads 237 and 252 and interconnect line 240) associated with microcoil structure 200 may be patterned in a separate processing step from device contact pads 212. In addition, the wire bonding procedure utilized to form wires 260(1) and 260(2) may be performed separately from that used to form device bonding wires 115. For example, a first wire bonding process may be used to wires 260(1) and 260(2) before a wafer including microcoil structure 200 is diced, and a second wire bonding process may be used to form device bonding wires 115 after dicing.

Note that, just like with conventional contact pads used for wire bonding to IC packaging, the contact pads and end pads of microcoil structure 200 should not be formed on top of active circuitry of the underlying IC device because the wire bonding process may damage this underlying circuitry. Currently, it is believed preferable to form the pads on top of large capacitors or over empty (unused) areas of substrate 210.

Figs. 5 and 6 are side elevation and plan views, respectively, showing microcoil structure 200 in additional detail.

Referring to Fig. 5, note that each wire 260(1) and 260(2) includes a first end 262 mounted on a pad 237/242, a second end 267 mounted on a pad 252/247, and an arched central portion extending over upper surface 215 of substrate 210 between pad 237/242 and pad 252/247. Arched central portion 265 of each wires 260(1) and 260(2) defines a circular radius R1 in the range of 20 microns to 1 mm in order to provide a substantially circular shape that maximizes the inductance of microcoil structure 200 while minimizing wire length. Specifically, unlike conventional bonding wires 115 (shown in Fig. 3), which are typically flattened to minimize resistance and inductance, the lengths of wires 260(1) and 260(2) are intentionally increased and rounded to produce an optimal microcoil. Extensive expertise exists in the art of forming bonding wires in a variety of shapes for probing purposes that facilitates producing wires 260(1) and 260(2) in the arched shape described herein. An example of a company having such expertise is FormFactor, Inc., of Livermore, California.

Referring to Fig. 6, during operation, an electrical current passes from first contact pad 237, along first wire 260(1) (i.e., over substrate 210) to end pad 242, along interconnect line 240 to end pad 247, and then along second wire 260(2) (i.e., over substrate 210) to second contact pad 252. As indicated in Fig. 6, in accordance with another aspect of the first embodiment, wires 260(1) and 260(2) of microcoil structure 200 are arranged in parallel planes P1 and P2, and interconnect line 240 is aligned diagonal to planes P1 and P2 (note that wires 260(1) and 260(2) need not be parallel in all embodiments). Accordingly, magnetic flux lines (indicated by dashed arrows) representing the resulting magnetic field, which is generated by this electrical current, are substantially contained within a passage passing through wires 260(1) and 260(2). That is, because the axis of microcoil structure 200 (i.e., a line passing through the centers defined by wires 260(1) and 260(2)) is horizontal (i.e., parallel to surface 215) and located above upper surface 215, few magnetic flux lines intercept the substrate 210, thereby minimizing induced eddy currents that cause ohmic losses in substrate 210 or can disrupt the IC device formed in substrate 210. By maintaining the magnetic field over the substrate, significant performance advantages are provided in comparison to conventional in-plane coil structures (described above). Note that, in other embodiments (such as toroids), the wires are not aligned in parallel planes.

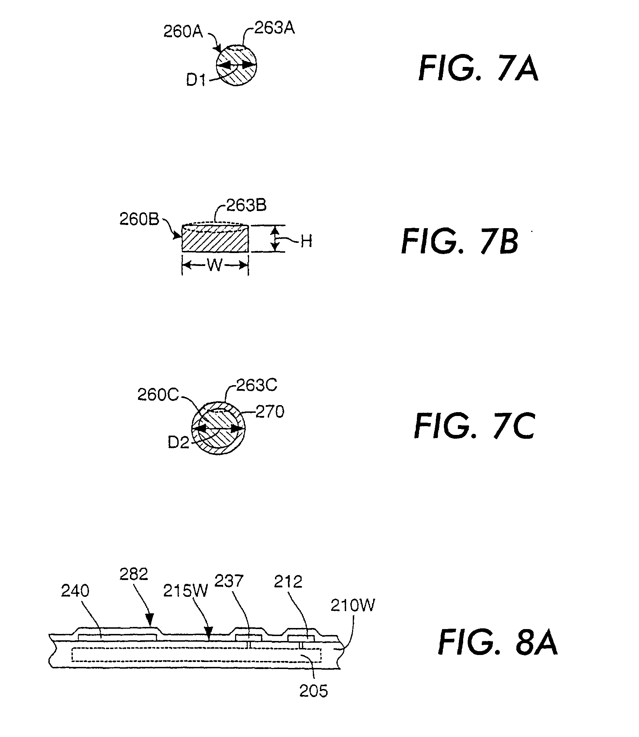

Figs. 7(A) through 7(C) are cross-sections of various wires 260A through 260C that are used in optional embodiments of the present invention.

Fig. 7(A) shows a standard bonding wire 260A having a typical diameter D1 in the range of 15 to 75 microns. As discussed above, in certain high frequency applications in which the so-called skin-effect becomes significant, standard wire 260A may provide a non-optimal current carrying region 263A. In these high frequency applications, a thicker bonding wire (e.g., in the range of 75 to 500 microns) may be utilized to increase the size of current carrying region 263A.

Fig. 7(B) shows another optional wire 260B that is a less conventional ribbon bonding wire having a width W in the range of 20 to 100 microns, and a thickness (height) H in the range of approximately 10 to 20 microns. Ribbon bond wire has been used for interconnects in microwave circuits because of its lower resistance and lower parasitic inductance at higher frequencies. Its use, however, requires wedge bonding techniques, as opposed to the conventional ball bonding. In past decades, ribbon wires were also attached by the now obsolete thermocompression, parallel-gap welding or solder reflowing techniques, all of which can also be used to produce inductors using flat ribbon wire 260B. Although potentially more expensive, flat ribbon wire 260B is optimal for forming the microcoil structures of the present invention because it provides a larger current carrying region 263B at high frequency than that possible with the round wires of comparable size.

Fig. 7(C) shows another optional wire 260C that includes a standard wire coated with a low-resistance metal 270, such as copper, such that the diameter D2 of wire 260C is in the range of 20 to 500 microns. Coating 270 serves both to increase the diameter of a standard bonding wire, hence reducing the so-called skin effect in high frequency applications by increasing the size of current carrying region 263C, and to reduce resistance at the junction between wire 260C and the contact/end pads (not shown) upon which wire 260C is placed. However, the application of metal coating 270 over a bonding wire (e.g., as shown in Fig. 7(C)) requires a special production process that includes a two-step wire bonding procedure, which is described in the following paragraphs.

Figs. 8(A) to 8(H) show an alternative method for producing IC devices with on-chip microcoil structures 200 includes forming (e.g., electroplating) low-resistance metal coating 270 on microcoil bonding wire 260C at the wafer level (i.e., before dicing a wafer to form individual IC substrates). This alternative method requires placing microcoil wires 260C using an additional wire bonding process that is performed before wafer dice (e.g., before packaging of the individual IC substrates). As noted above, an advantage to producing microcoil structures 200 using uncoated microcoil wires (e.g., wire 260A; see Fig. 7(A)) is that these microcoil wires can be formed during the same wire bonding process utilized during IC device packaging. In contrast, because electroplating is typically performed at the wafer level, an additional wire bonding process must be performed before the wafer is diced to form individual IC substrates. Although the resulting two-step wire bonding process of the present embodiment increases the number of production steps (and, hence, the chip manufacturing cost of the IC devices), metal coating 270 improves the operating performance of the resulting microcoil structures, thereby justifying these additional costs in some high frequency applications.

Referring to Fig. 8(A), after the fabrication of electronic circuitry (e.g., one or more IC devices 205) on a wafer 210W, conductive traces (e.g., first contact pad 237, interconnect line 240, and one or more device contact pads 212) are formed on an upper insulating layer (surface) 215W that is formed over IC device 205 on wafer 210W. Note that openings are formed through upper insulating layer 215W to provide electrical connection between IC device 205 and selected conductive traces. After the conductive traces are formed, a seed layer 282 (e.g., a bondable metal such as gold) is then grown on wafer 210W such that seed layer 282 electrically connects the conductive traces formed on upper insulating layer 215W to facilitate the electroplating process, described below.

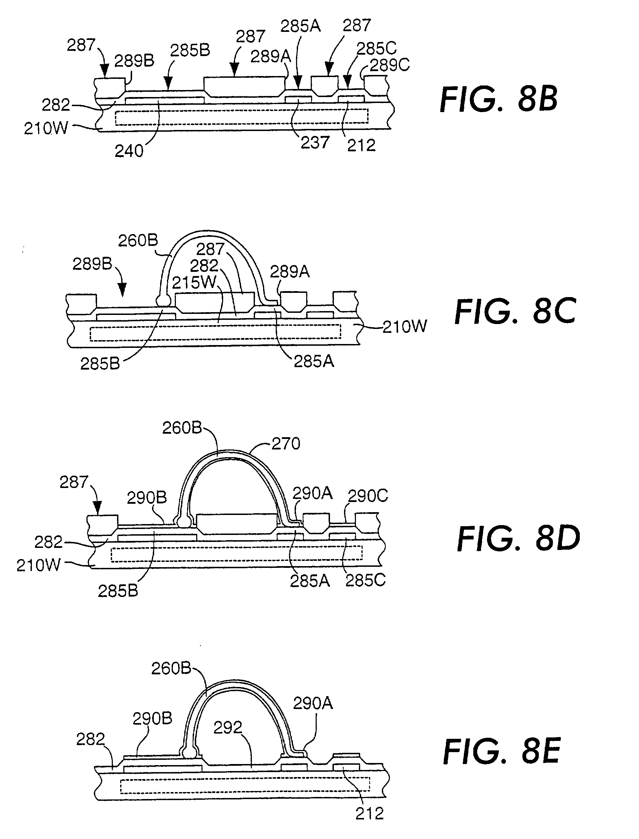

Referring to Fig. 8(B), a photoresist mask 287 is then formed (e.g., spun, exposed and developed) on seed layer 282 to protect regions of wafer 210W that do not require electroplating. In particular, mask 287 defines windows 289A and 289B that expose portions 285A and 285B of seed layer 282, which are located over first contact pad 237 and interconnect line 240, respectively. An optional window 289C is defined to expose a third portion 285C of seed layer 282, which is located over device contact pad 212.

Referring to Fig. 8(C), a first (pre-wafer dice) wire bonding process is then performed to place a first wire 260C on wafer 210W such that a central arched portion of first wire 260C extends over wafer 210W (i.e., over the mask 287, seed layer 282, and insulating layer 215W). The respective ends of wire 260C extend through openings 289A and 289B and contact seed layer portions 285A and 285B, respectively. Note again that this first wire bonding process is performed at the wafer level (i.e., before wafer 210W is diced).

Referring to Fig. 8(D), metal coating 270 is then formed on first wire 260C. In one embodiment, metal coating 270 is formed using known electroplating techniques (e.g., immersing wafer 210W in a container (not shown) that holds an electroplating solution). Given the 2-5 µm skin depth of current in region 263C (see Fig. 7(C)) at high frequencies, and given the typical 1 micron or less thickness of the conductive traces, it is desirable to plate contact pad 237 and interconnect line 240. Accordingly, windows 289A and 289B are provided to expose seed layer portions 285A and 285B, respectively, during the electroplating process. By controlling the parameters of the electroplating process using known techniques, the exposed metals (i.e., wire 260C and seed layer portions 285A, 285B, and 285C) are plated to a desired thickness using seed layer 282 and wire 260A as the cathode. In particular, metal coating 270 is formed on wire 260C, and metal portions 290A and 290B, along with optional metal portion 290C, are respectively formed on exposed seed layer portions 285A, 285B, and 285C.

Referring to Fig. 8(E), the mask is then removed using known techniques, thereby exposing unplated portions of seed layer 282. Note that at this point in the production process the opposing ends of coated wire 260C remain electrically coupled by a seed layer portion 292, which extends between metal portions 290A and 290B. Similarly, device contact pad 212 remains coupled to wire 260C by seed layer 282.

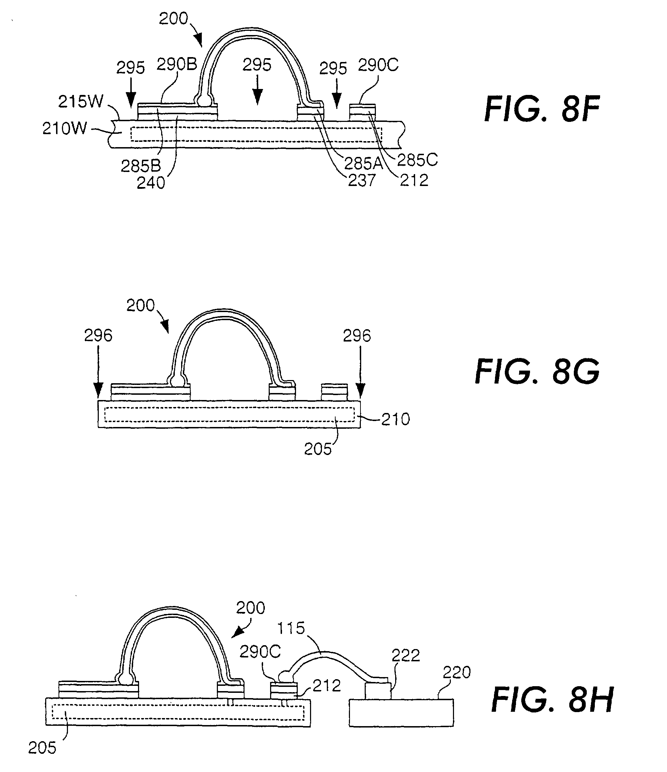

Referring to Fig. 8(F), an etchant 295 is then used to remove the exposed portions of the seed layer, thereby electrically isolating the various conductive traces and exposing upper insulating layer 215W of wafer 210W. By selecting a seed layer material that is different from the plated metal, the seed material can be effectively removed without damaging metal portions 290A, 290B, and 480C, and/or damaging metal coating 270 on wire 260C. Note that seed layer portions 285A, 285B, and 285C are protected during this etching step such that they remain sandwiched between metal portions 290A, 290B, and 290C and contact pad 237, interconnect line 240, and device contact pad 212, respectively. Microcoil structure 200 is essentially completed after the etching step.

Referring to Fig. 8(G), the wafer is then diced (indicated by arrow 296) to form individual IC substrates 210, each substrate including an integrated circuit 205 and on-chip microcoil structure 200.

Finally, as shown in Fig. 8(H), an optional second wire bonding procedure is performed to connect integrated circuit 205 to external structure 220 (also shown in Fig. 4) using conventional bonding wire 115 that extends between metal portion 290C and a corresponding pad 222. Note that metal portion 290C is optionally provided to reduce contact resistance, and may be omitted (i.e., conventional bonding wire 115 may be connected directly onto device contact pad 212).

In yet another alternative production method that avoids the need for seed layer 282, mask 287, and etchant 295 (all described above), contact pads associated with the various of microcoil structures formed on a wafer can be connected by a common conductive trace grid. Note that the conductive trace grid must be severed during the wafer dicing procedure (i.e., after electroplating is performed). In this alternative embodiment, pre-dicing wire bonding is performed to connect the microcoil wires between associated conductive trace regions (e.g., such that wire 260C is connected directly to contact pad 237 and interconnect line 240). Electroplating is then performed (e.g., by immersing the wafer in a container that holds an electroplating solution) to plate the exposed metals to the desired thickness using the microcoil wires and conductive trace grid as the cathode. Dicing is then performed to separate the various IC devices (i.e., the conductive trace grid is severed to decouple the microcoil structures. Finally, an optional second wire bonding procedure is performed to connect each IC device to, for example, a package using conventional bonding wire 115 (see Fig. 4).

Those of ordinary skill in the art will recognize that the above-described simplified microcoil structure 200 can be utilized to form several practical electric components, several of which are described below with reference to certain specific embodiments shown in Figs. 8 through 14. The disclosed specific embodiments are intended to be exemplary and not limiting.

### Inductors

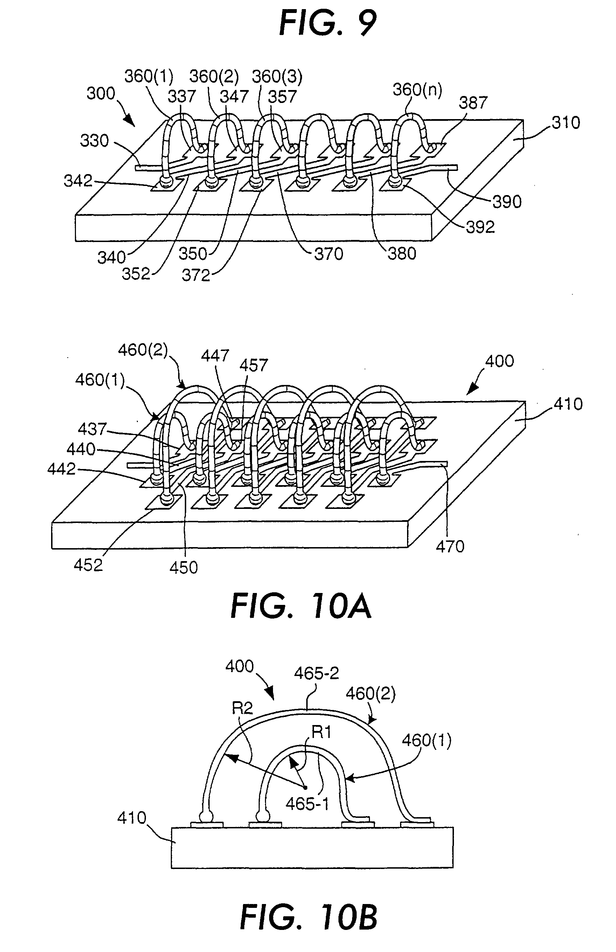

Figs. 9 through 13(B) show various the on-chip out-of-plane inductors constructed in accordance with the present invention.

Fig. 9 is a perspective view showing a basic in-line inductor 300 formed on a substrate 310 in accordance with a second embodiment of the present invention. Inductor 300 includes a basic microcoil structure similar to that described above, and several additional interconnect lines and bonding wires that increase the inductance of inductor 300 to a desired level. The basic microcoil structure includes a first contact pad 337 that is connected to an input terminal 330, a first interconnect line 340, a second contact pad 352, a first wire 360(1) and a second wire 360(2). In addition to this basic microcoil structure, inductor 300 includes several additional wires aligned in parallel planes, and interconnect lines that are aligned diagonal to the wires. For example, second contact pad 352 is located at an end of a second interconnect line 350 that is formed on substrate 310 in a direction parallel to first interconnect line 340. A second end (third contact) pad is formed at a second end of interconnect line 350 that is connected by a third wire 360(3), which lies in a plane parallel to wires 360(1) and 360(2), to an end (fourth contact) pad 372. End pad 372 is connected at one end of a third interconnect line 370, which is also parallel to first interconnect line 340 and second interconnect line 350. The number of additional wires and interconnect lines arranged in this manner is selected to collectively provide a desired inductance value. This pattern is repeated until sufficient "windings" (i.e., turns formed by wires and interconnect lines) are provided by the wires and interconnect lines to produce the desired inductance. A final wire 360(n) is provided between an end pad 387 of a final interconnect line 380 and a final contact pad 392 connected to an output terminal 390.

Although the in-line microcoil arrangement shown in Fig. 9 can be lengthened by adding additional wires and interconnect lines to achieve a desired inductance, practical space limitations on an IC substrate may provide a space that is too small for a given limitation. Accordingly, third and fourth embodiments of the present invention, described below, provide alternative structures that facilitate increased inductance for a given inductor length.

Figs. 10(A) and 10(B) are perspective and side elevation views showing an inductor 400 formed on a substrate 410 in accordance with the third embodiment of the present invention. As shown in Fig. 10(A), inductor 400 includes a microcoil structure made up of wires having different sizes (radii) to avoid spacing issues related to conventional wire bond equipment. That is, given the bondwire thickness and the size of the bonder head, the pitch of wires 460(1)...460(n) is currently limited to approximately 35 to 50 microns. A double layer structure, such as that shown in Fig. 10(A), or even a triple layer structure (not shown) can produce a finer pitch, if needed. Specifically, according to the third embodiment, the density of bonding wires is increased beyond that of the second embodiment (see Fig. 9, above) by placing a first group (layer) of bonding wires having relatively smaller radii on substrate 410, and then placing a second group (layer) of bonding wires having relatively larger radii such that the two groups are connected together to form a single inductor.

Fig. 10(B) shows representative wires of the two groups. In the first group, including wire 460(1), each wire has an arched central portion that defines a relatively smaller radius R1 (e.g., 100 microns). In the second group, including wire 460(2), each wire has an arched central portion that defines a relatively larger radius R2 (e.g., 200 microns). The different radii R1 and R2 are selected to provide the desired inductance and in accordance with wire bond equipment specifications to avoid contact during the wire bonding process.

Referring again to Fig. 10(A), the different sized groups of wires are alternately placed such that, for example, each wire of the second group is positioned between two wires of the first group. To facilitate this wire placement arrangement, the conductive traces formed on substrate 410 are patterned in a staggered arrangement such that the contact/end pads are alternately closely spaced (i.e., to accommodate wires of the first group) and widely spaced (to accommodate wires of the second group). Referring to Fig. 10(A), first pad 437 and first end pad 442 (.which is connected to first interconnect line 440) are relatively closely spaced to accommodate connections to wire 460(1). In contrast, second end pad 447 and second contact pad 452 (which is connected to second interconnect line 450) are relatively widely spaced to accommodate connections to wire 460(2). The subsequent placement of wires is performed by placing all wires of the first group between corresponding closely-spaced pads, and then placing the wires of the second group between corresponding widely-spaced pads. The resulting alternating placement pattern of a small radius wire followed by a large radius wire is repeated along the length of inductor 400 to output terminal 470, thereby providing a larger number of "windings" than would otherwise be allowed if all of the wires were the same size. Accordingly, for a given inductor length, an inductor formed in accordance with the third embodiment would have a greater inductance than an inductor formed in accordance with the second embodiment (see Fig. 9).

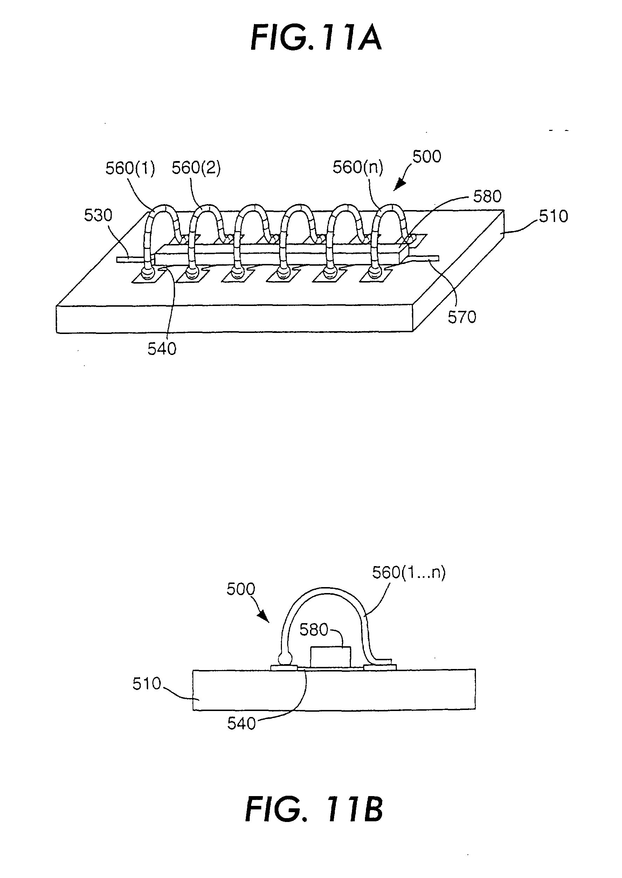

Figs. 11(A) and 11(B) are perspective and side elevation views showing an inductor 500 formed on a substrate 510 in accordance with the fourth embodiment of the present invention. In accordance with another aspect of the present invention, the basic microcoil structure easily accepts magnetic coils to increase inductance, confine the magnetic field, or create transformers (discussed below). As indicated in Fig. 11(A), inductor 500 includes a core structure 580 formed, for example, from ferrite that is sintered or mixed with an suitable adhesive to form an elongated bar that is then mounted over the conductive traces (e.g., interconnect line 540). Core structure 580 can also be deposited onto the underlying conductive traces using known fabrication techniques. Wires 560(1) through 560(n) are then placed in accordance with the methods described above such that core structure 580 extends through the arch formed by each of wires 560(1), 560(2)...560(n). Although Figs. 11(A) and 11(B) show a core utilized in a basic inductor similar to that shown in Fig. 9, a core structure can also be utilized in the inductor shown in Fig. 10(A). Accordingly, the inductance of an inductor formed in accordance with the present invention is further adjusted by selecting an appropriate core structure that is placed on the substrate over the interconnect lines such that the core structure extends through the arches formed by each of the wires.

In addition to ferrites, the optional core structures utilized in accordance with the present invention can be formed from ferromagnetic metals (e.g., iron, nickel, and various alloys) or any other material having a relative permeability greater than 1. Ferrites are optimal at high frequencies because they are isolators, and therefore do not produce eddy currents. Conversely, ferromagnetic metals are electrically conductive and therefore produce eddy currents, but may be desirable in low frequency applications because they are easily micromachined. Other suitable materials may also be utilized that have a relative permeability higher than 1 such that magnetic fields generated during operation tend to flow in the core instead of the surrounding air/vacuum/encapsulant.

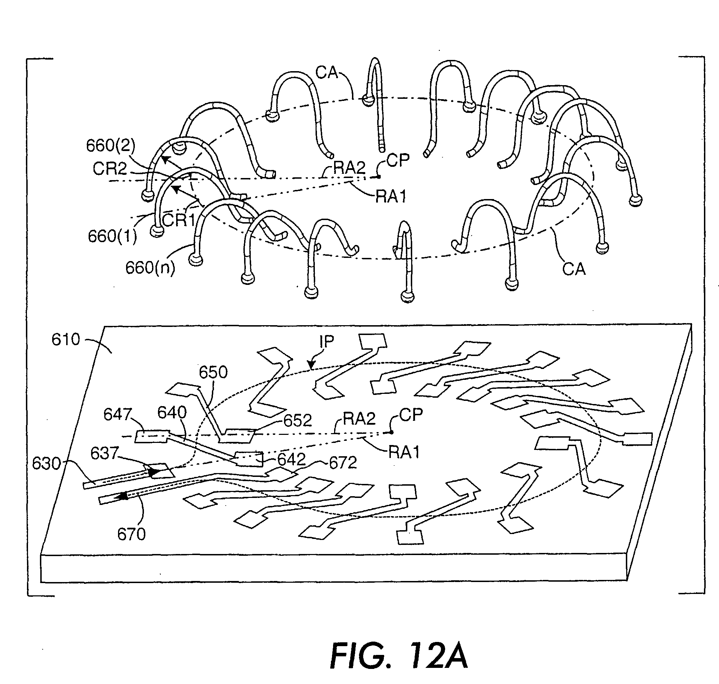

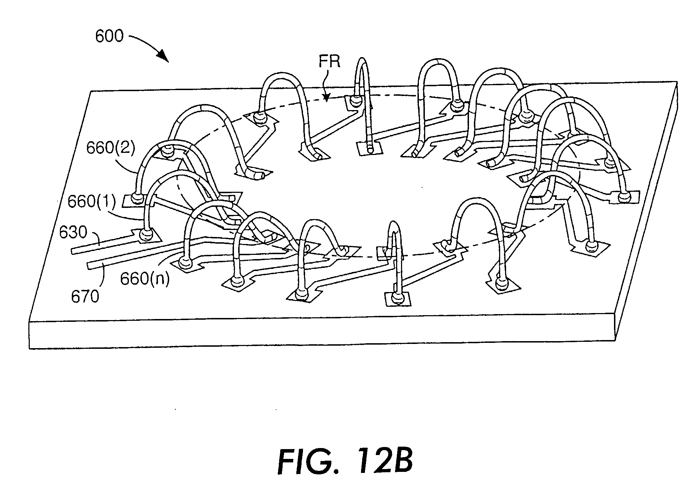

Figs. 12(A) and 12(B) are exploded perspective and perspective views, respectively, showing a toroidal inductor 600 formed on a substrate 610 in accordance with the fifth embodiment of the present invention. In particular, the center points defined by the arches of the wires form a toroidal flux region (e.g., region FR shown in Fig. 12(B)). For example, the center CR1 defined by wire 660(1) and the center CR2 defined by wire 660(2) are aligned along the dashed circular line shown in Fig. 12(A). This toroidal wire arrangement further confines the induced magnetic fields to regions above the surface of substrate 610, thereby further reducing eddy currents in underlying substrate 610. Specifically, the entire magnetic field exists inside the coil winding region FR, which is defined by wires 660(1) through 660(n), and the associated conductive traces. This feature enables the formation of multiple densely packed toroidal inductors 600 on substrate 610 without coupling with each other.

Referring to Fig. 12(A), toroidal inductor 600 is produced by first forming a series of conductive traces in a circular pattern such that the contact/end pads are aligned along radial axes extending from a center CP of the circle. For example, (first) contact pad 637, which is connected to an input terminal 630, is aligned with end pad 642, which is connected to first interconnect line 640, along a first radial axis RA1, which is connected to first interconnect line 640. Similarly, end pad 647, which is connected to interconnect wire 640, is aligned with end (second contact) pad 652, which is connected to second interconnect line 640, along a second radial axis RA2. Subsequently, as shown in Fig. 12(B), wires 630(1) through 630(n) are sequentially placed on substrate 610 such that each wire connects a corresponding pair of pads. For example, wire 660(1) is placed between first contact pad 637 and end pad 642, and then second wire 660(2) is placed between end pad 647 and second contact pad 652. Note that wires 630(1) and 630(2) are formed in respective vertical planes passing through first radial axis RA1 and second radial axis RA2, respectively. The wire bonding process continues until a final wire 660(n) is placed between a final interconnect line and output terminal 670.

Several modifications to toroidal inductor 600 can be incorporated that fall within the present invention. For example, wires 660(1) through 660(n) and the associated conductive traces can be arranged such that the conductive traces are aligned along radial axes (e.g., RA1 and RA2; see Fig. 12(A)), and wires 660(1) through 660(n) arranged diagonally to connected the conductive traces. Alternatively, both wires 660(1) through 660(n) and the associated conductive traces can be aligned diagonal to the radial axes. Further, a magnetic core may be inserted into toroidal inductor 600 in a manner similar to that described above with reference to Fig. 11(A) and 11(B). Moreover, toroidal inductor 600 is not limited to a circular shape, but can be formed in any suitable closed loop (e.g., a square, rectangular, or triangular shape), as is understood in the art.

### Transformers

In addition to inductors, the microcoil structure of the present invention can be used to form low-cost on-chip transformers.

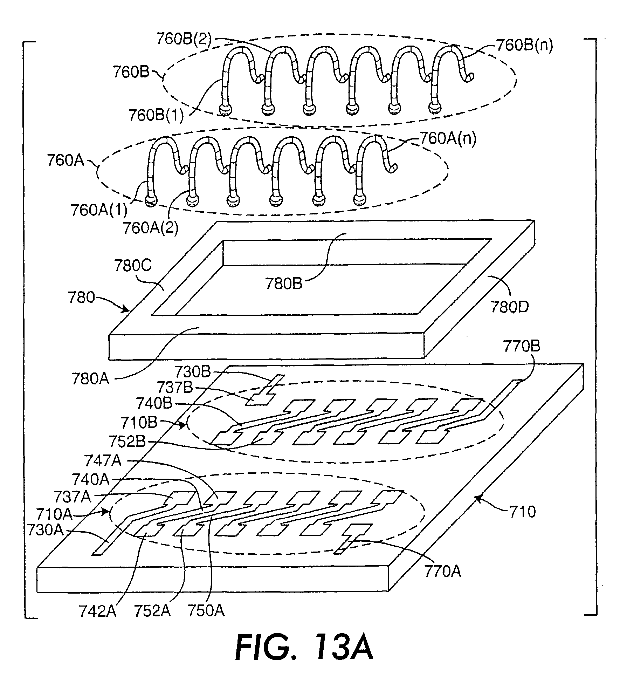

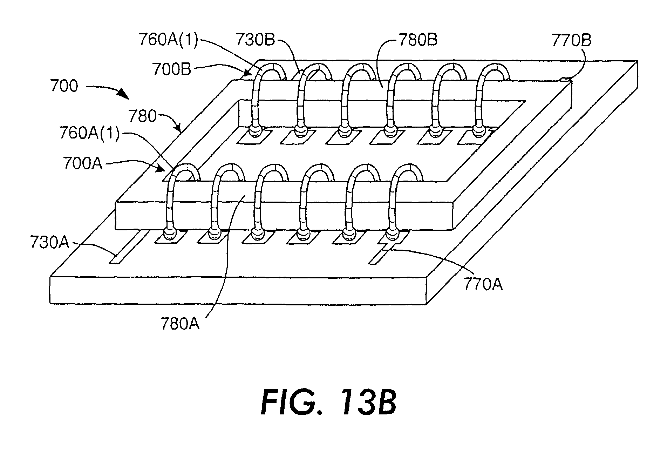

Figs 13(A) and 13(B) are exploded perspective and perspective views showing a 1:1 microcoil transformer 700 in accordance with a sixth embodiment of the present invention. Transformer 700 includes a first inductor 700A that is coupled to a second inductor 700B by a core structure 780. As indicated in Fig. 13(A), core structure 780 is formed in a frame (square or rectangular) shape having parallel end pieces 780A and 780B that are connected by end pieces 780C and 780D. Similar to the toroidal inductors 600, described above, transformer 700 is not limited to this frame shape, but can be formed in any suitable closed loop.

Referring to Fig. 13(A), transformer 700 is constructed in a manner similar to the inductors described in the above embodiments. A first group of conductive traces 710A and a second group of conductive traces 710 B are formed on substrate 710. Each group includes contact pads and interconnect lines that are consistent with the microcoil structures of the present invention. For example, group 710A includes a first contact pad 737A, which is connected to a first input terminal 730A, a first interconnect line 740A having end pads 742A and 747A, and an interconnect line 750A having an end (second contact) pad 752A. Similarly, group 710B includes a third contact pad 737B, which is connected to a second input terminal 730B, a (second) interconnect line 740B, and an interconnect line 750B having an end (fourth contact) pad 752B.

After conductive trace groups 710A and 710B are formed on substrate 710, core structure 780 is placed on substrate 710 over the conductive traces such that the contact/end pads are exposed on each side of end pieces 780A and 780B. For example, core structure 780 can be a preformed (e.g., ferrite) core similar to that described above, or can be built in place using micromachining fabrication techniques. Finally, two groups of wires 760A and 760B are placed using wire bond equipment such that each wire extends over a portion of core structure 780 (i.e., core structure 780 extends through arches formed by each of the wires associated with first inductor 700A and second inductor 700B). For example, as shown in Fig. 13(B), wire 760A(1) extends over a portion of end piece 780A to connect first contact pad 737A and end pad 742A (both shown in Fig. 13(A)). The remaining wires associated with first inductor 700A are similarly formed over end piece 780A. Similarly, wire 760B(1) extends over a portion of end piece 780A to connect first contact pad 737B and end pad 742B (both shown in Fig. 13(A)), and the remaining wires associated with second inductor 700B are similarly formed over end piece 780B.

During operation, core structure 780 couples first inductor 700A to 700B to transfer currents according to a ratio of the wires connected over end pieces 780A and 780B.

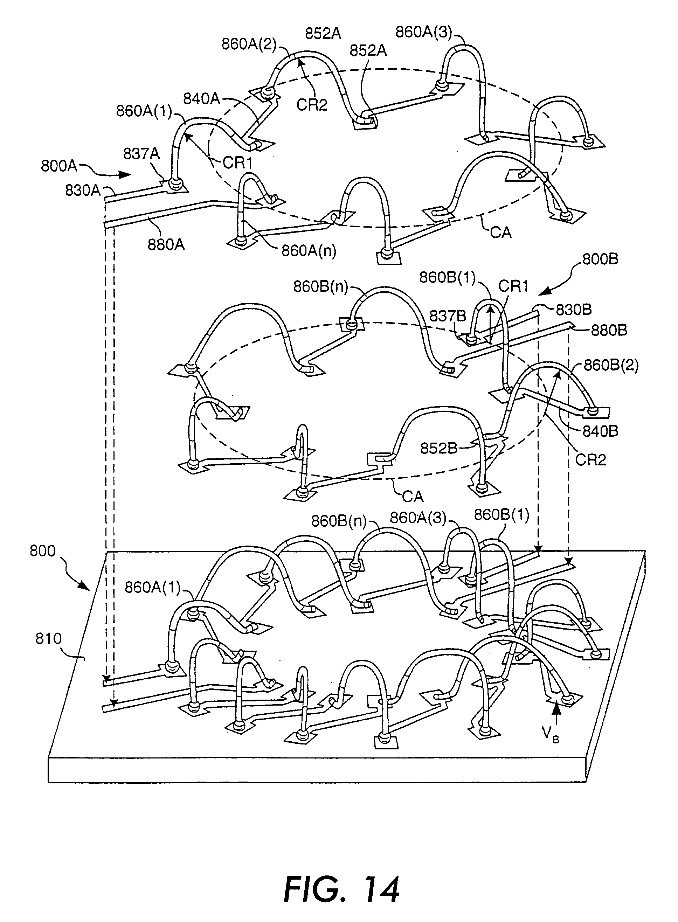

Fig. 14 is a perspective view showing an intertwined air-core transformer 800 in accordance with a seventh embodiment of the present invention. Air-core transformer 800 includes a first inductor 800A and a second inductor 800B that are drawn above substrate 810 for clarity. Each inductor includes interconnect lines and wires that are connected in a toroid-like manner such that each wire of first inductor 800A (e.g., 860A(3)) is located between two wires of second inductor 800B (e.g., 860B(n) and 860B(1)). Similarly, each wire of second inductor 800B is located between two wires of first inductor 800A.

Referring to the upper portion of Fig. 14, first inductor 800A includes a basic microcoil structure similar to that described above, and several additional interconnect lines and bonding wires that increase the inductance of inductor 800A to a desired level. The basic microcoil structure of inductor 800A includes a first contact pad 837A that is connected to an input terminal 830A, a first interconnect line 840A, a second contact pad 852A, a first wire 860A(1) and a second wire 860A(2). These and the remaining conductive traces and wires associated with first inductor 800A are arranged in a circle that ends with a final wire 860A(n) that contacts a contact pad 882A connected to an output terminal 880A.

Shown below first inductor 800A is second inductor 800B. Second inductor 800B includes a basic microcoil structure similar to that described above, and several additional interconnect lines and bonding wires that increase the inductance of inductor 800B to a desired level. The basic microcoil structure of inductor 800B includes a first contact pad 837B that is connected to an input terminal 830B, a first interconnect line 840B, a second contact pad 852B, a first wire 860B(1) and a second wire 860B(2). These and the remaining conductive traces and wires associated with first inductor 800B are arranged in a closed loop (e.g., a circle or an oval) that ends with a final wire 860B(n) that contacts a contact pad 882B connected to an output terminal 880B.

As indicated at the lower portion of Fig. 14, transformer 800 combines first and second inductors 800A and 800B such that they couple during operation. Note that first inductor 800A and second inductor 800B are separated at the top of Fig. 14 for illustrative purposes only, and that all of the conductive traces associated with first inductor 800A and second inductor 800B are patterned simultaneously on substrate 810. Note also that wires associated with both inductors can be placed in any selected order. A toroidal magnetic core is not required for proper coil coupling, but may be selected to increase the coil inductance to a desired level.

Note also that transformer 800 may be easily modified to form a balanced/unbalanced transformer (aka, balun) by providing an additional terminal to a centrally-located wire of one of the two inductors, as indicated by the arrow located in the lower right portion of Fig. 14.

### Applications

On-chip microcoil structures produced in accordance with the present invention have numerous practical applications. For example, when produced with inductance values in the range of 1 to 100nH, the microcoil structures of the present invention are optimally suited for use in mobile RF communication devices that operate in a frequency range of approximately 100MHz to several GHz. One such mobile communication device is a Global System for Mobile Communication (GSM) digital cell phone.

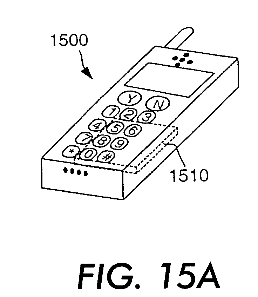

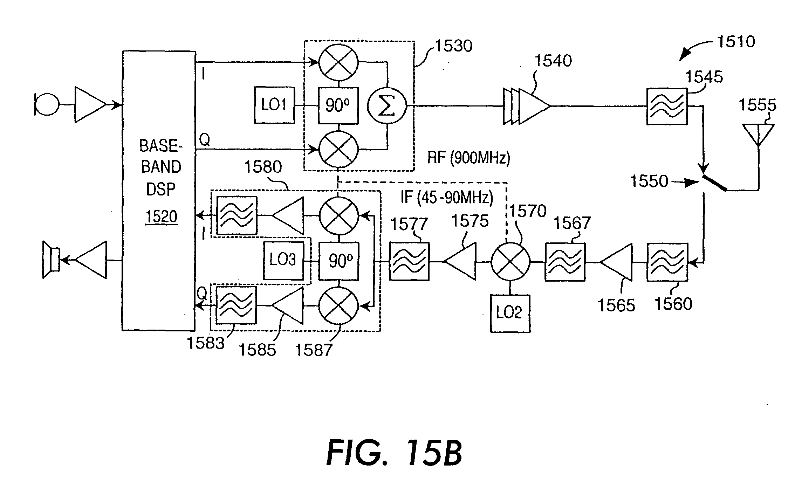

Figs. 15(A) and 15(B) are perspective and simplified circuit diagrams showing a GSM digital cell phone 1500, which is an example of a mobile communication device that is suited for utilizing one or more microcoil structures of the present invention.

Fig. 15(A) shows a circuit substrate in dashed lines that includes a radio circuit section 1510 utilizing the on-chip microcoil structures.

Fig. 15(B) is a circuit diagram showing radio circuit section 1510 in additional detail. Note that several different modulation schemes and data formats are utilized in modern cell phones, but radio circuit section 1510 is common to all radio circuits in that it involves a combination of amplifiers, modulators, filters and oscillators. A digital signal processor (DSP) 1520 picks up an amplified microphone signal, converts the amplified microphone signal to digital data, and translates the digital data as I/Q signals that are then phase modulated on a 900MHz carrier by quadrature modulator 1530. A power amplifier 1540 then amplifies the modulated signals are then amplified by a filter 1545 and routed by a switch 1550 to an antenna 1555. The receiver portion of radio circuit section 1510 follows the reverse procedure, often with a two-step frequency conversion for easier channel separation. The antenna signal is first filtered by filter 1560, amplified and filtered by an amplifier 1565 and a filter 1567, and demodulated by mixer 1570 to an intermediate frequency (IF) signal. This IF signal is then amplified by amplifier 1575 and filtered again by filter 1577 to select the channel of interest. The I/Q signals are then recovered by a demodulation circuit 1580 that demodulates the IF signal using two 90° out-of-phase sinusoidal voltages of frequency IF using mixers 1583, amplifiers 1585 and filters 1587. DSP 1520 finally turns the I/Q information into audio signals to drive a loudspeaker 1590.

In radio circuits such as radio circuit section 1510, microcoil structures of the present invention can be beneficially utilized, for instance, as part of the resonator of a tuned amplifier (e.g., amplifiers 1540 and 1565) or an oscillator (such as local oscillator LO1, which is shown in Fig. 15(B)), as filter components (e.g., filters 1545, 1560, 1567, or 1577), as baluns utilized by mixer circuit 1530 and demodulation circuit 1580, and as matching elements between two sub-circuits (e.g., modulator 1530 and power amplifier 1540). Some of these specific applications are described in additional detail below.

### Filters

The various filters used in the RF and IF circuit sections of radio circuit section 1510 (i.e., filters 1545, 1560, 1567, and 1577) are potential candidates for utilizing the on-chip microcoil structures of the present invention. These filters are used in situations where the frequencies are high enough to be compatible with small microcoil structures. The I/Q receiver filters (e.g., filter 1583) typically run at a low frequency that is not optimal for utilizing the microcoil structures. These filters are often implemented as active filters or switched-capacitor circuits that are easy to integrate on a chip.

Antenna filters, such as filters 1545 and 1560, are typically a fairly simple combination of inductors and capacitors in a band-pass configuration. Antenna 1555 picks up RF signals over a wide spectrum of frequencies. Antenna filter 1560 roughly selects the frequency band of interest to cancel out-of-band noise and to reduce the signal level at the receiver input to allow for a higher receiver gain and thus better sensitivity. Inductor-capacitor filters are used in this situation instead of resistor-capacitor filters because of the loss and noise correlated to resistors. The microcoil structures of the present invention can be used as antenna-filter inductors. The filter capacitors can be implemented as part of the circuit integrated on the die underneath the microcoil structures in cases where the IC process includes capacitors, or can be added after IC fabrication on top of the substrate in IC processes that do not include capacitor fabrication steps.

### Mixers

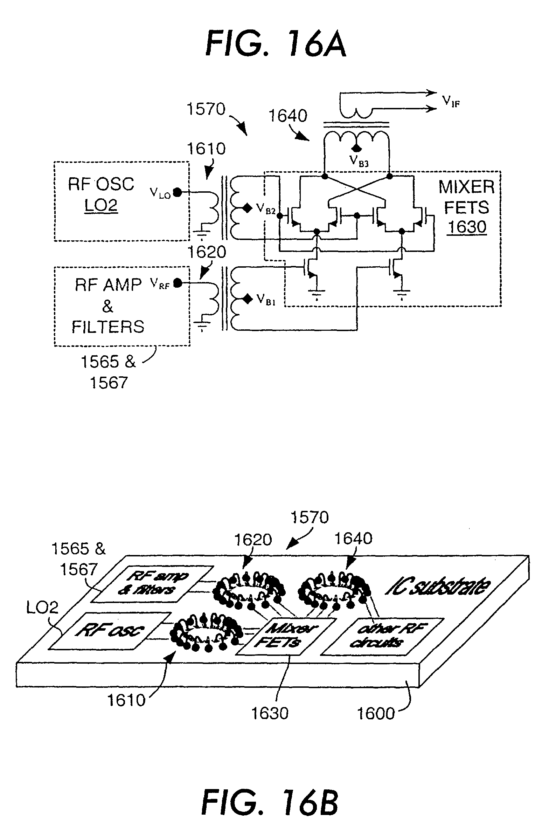

Figs. 16(A) and 16(b) are simplified circuit and perspective diagrams showing an example of a double balanced RF-to-IF mixer 1570 of radio circuit section 1510. RF-to-IF mixer 1570 is based on the Gilbert multiplier, and is disclosed in "RF and Microwave Circuit Design for Wireless Communications", Larson L.E., Editor, Artech House Publishers, Boston, London, 1997, ISBN 0-89006-816-6 (page 273, Fig. 5.33).

Referring to Fig. 16(A), RF-to-IF mixer 1570 includes a first balun 1610 for receiving a reference signal V_{LO} from RF local oscillator LO2, a second balun 1620 for receiving amplified signal VRF, a mixer FET circuit 1630, and a third balun 1640 for generating an IF output signal that is transmitted to demodulation circuit 1580. Mixer FET circuit 1630 is indicated as being implemented using NMOS technology, but can also be made using bipolar transistors or JFETs. Baluns 1610, 1620, and 1640 convert asymmetric signals into symmetric signals and vice versa in a manner known in the art.

Fig. 16(B) is a perspective view showing RF-to-IF mixer 1570 arranged on an IC substrate 1600. Other components of radio circuit section 1510 are omitted for clarity. In accordance with the present invention, baluns 1610, 1620, and 1640 are implemented using the air-coil transformer arrangement shown in Fig. 14.

### Amplifiers with inductive load

RF receiver amplifiers (e.g., amplifier 1565) often utilize inductors instead of resistors for the load and the emitter degeneration for low-noise operation (no thermal kTxR noise). Power amplifier 1540 also often contains inductors instead of resistors for better efficiency (no Rxl² losses in resistors) and higher output swing. A load coil allows an output swing up to two times the supply voltage instead of one time as with a resistor load. Examples of these amplifiers are disclosed in "RF and Microwave Circuit Design for Wireless Communications", pages 368 (Fig. 7.13) and 385 (Fig. 7.26), which is cited above, and incorporated herein by reference.

### PLLs and VCOs

The local oscillators LO1 and LO2 of radio circuit section 1510 (shown in Fig. 15(B)) are typically phase-locked-loop circuits. The purpose of a PLL is to generate an adjustable frequency signal with the accuracy and stability of the crystal oscillator. A frequency-divided output of the voltage-controlled oscillator is compared to a reference signal generated by the crystal oscillator. As soon as the phase of the VCO deviates from the reference signal, the phase comparator outputs a voltage that adjusts the VCO frequency. A filter is typically provided between the phase comparator and the VCO to assure loop stability. The VCO can be forced to run at different frequencies by adjusting the scale-down factor of the frequency scaler.

VCOs are a special class of oscillators in which the resonance frequency of the resonator is voltage dependent. This is most often accomplished by combining a fixed coil with a variable capacitor. Commercial VCO's use varactor diodes as tuning capacitor. MEMS varactors, which are described in co-pending U.S Patent Application Serial No. 09/573,363, filed May 17, 2000, which is incorporated herein by reference. The microcoil structures of the present invention are perfectly suited in the VCO resonator for the fixed coil utilized with such a varactor diode.

Note that the range of applications is not limited to mobile RF applications, such as those described above. The microcoil structures can be applied to any circuit that requires one or more inductors in the range of 1 to several 100nH where the required coil currents do not exceed the maximum rating of the coil windings.

## Claims

1. A microcoil structure comprising:
a substrate;
first and second spaced-apart contact pads formed on the substrate;
an elongated first interconnect line formed on the substrate adjacent to the first and second spaced-apart contact pads;
a first wire extending over the substrate between the first contact pad and a first end of the first interconnect line; and
a second wire extending over the substrate between the second contact pad and a second end of the first interconnect line.

2. The microcoil structure according to Claim 1,
wherein the first interconnect line includes a third contact pad located at the first end thereof, and a fourth contact pad located at a second end thereof,
wherein the first wire contacts the third contact pad, and
wherein the second wire contacts the fourth contact pad.

3. The microcoil structure according to Claim 1, wherein each of the first and second wires has an arched central portion.

4. The microcoil structure according to Claim 1, wherein the first and second wires define parallel planes.

5. The microcoil structure according to Claim 1, wherein each of the first and second wires has rectangular cross section.

6. The microcoil structure according to Claim 1, further comprising:
a third contact pad formed on the substrate and connected to the second contact pad by an elongated second interconnect line;
a fourth contact pad formed on the substrate; and
a third wire extending over the substrate between the third contact pad and the fourth contact pad.

7. The microcoil structure according to Claim 1, further comprising an elongated core structure positioned on the substrate over the first interconnect line, wherein the core structure extends through an arch formed by each of the first and second wires.

8. The microcoil structure according to Claim 1,
wherein the first and second wires form arches defining respective centers, and
wherein the first and second wires are arranged in a toroidal shape such that the respective centers define a closed loop.

9. An inductor comprising a microcoil structure according to one of the Claims 1 to 8.

10. A method for forming a microcoil structure on an integrated circuit substrate, the method comprising:
forming a plurality of conductive traces on the substrate, wherein the plurality of conductive traces include first and second spaced-apart contact pads, and an elongated first interconnect line formed on the substrate adjacent to the first and second spaced-apart contact pads;
placing a first wire on the substrate such that the first wire extends over the substrate between the first contact pad and a first end of the first interconnect line; and
placing a second wire on the substrate such that the second wire extends over the substrate between the second contact pad and a second end of the first interconnect line.
